# EUROPEAN PATENT APPLICATION

(11) **EP 1 408 564 A2**
(43) Date of publication of application: **14.04.2004**
(21) Application number: 03078067.0
(22) Date of filing: 26.09.2003
(51) Int. Cl.: H01L 51/40, B41M 5/26, B41M 5/38

(54) **Laser thermal transfer gap control for OLED manufacturing**

(30) Priority: 08.10.2002 US 266828
(71) Applicant: EASTMAN KODAK COMPANY, Rochester, New York 14650 (US)
(72) Inventor: Burberry, Mitchell S., c/o Eastman Kodak Company, Rochester, New York 14650-2201 (US); Vazan, Fridrich, c/o Eastman Kodak Company, Rochester, New York 14650-2201 (US)
(74) Representative: Weber, Etienne Nicolas

(57) **Abstract**

A method for depositing onto a substrate an organic emitter layer in the process of making an OLED device, includes providing a donor element coated with the organic emitter layer having an organic emitter having a desired emission spectrum and which when subject to heat transfers to the substrate; positioning the coated side of the donor element in a material transferring relationship at a predetermined distance relative to the substrate to deposit the emitter layer in an environment of reduced pressure, the predetermined distance being selected so that the spectrum of light emitted from the OLED device will be in the desired emission spectrum; and heating the donor element to cause the transferable layer to transfer to form the emitter layer on the organic light-emitting device.

## Description

The present invention relates to the manufacture of OLED devices.

In color or full-color organic electroluminescent (EL) displays having an array of colored pixels such as red, green, and blue color pixels (commonly referred to as RGB pixels), precision patterning of the color-producing organic EL media is required to produce the RGB pixels. The basic EL device has in common an anode, a cathode, and an organic EL medium sandwiched between the anode and the cathode. The organic EL medium may consist of one or more layers of organic thin films, where one of the layers is primarily responsible for light generation or electroluminescence. This particular layer is generally referred to as the emissive layer of the organic EL medium. Other organic layers present in the organic EL medium may provide electronic transport functions primarily and are referred to as either the hole transport layer (for hole transport) or electron transport layer (for electron transport). In forming the RGB pixels in a full-color organic EL display panel, it is necessary to devise a method to precisely pattern the emissive layer of the organic EL medium or the entire organic EL medium.

Typically, electroluminescent pixels are formed on the display by shadow masking techniques, such as shown in US-A-5,742,129. Although this has been effective, it has several drawbacks. It has been difficult to achieve high resolution of pixel sizes using shadow masking. Moreover, it is challenging to align the substrate and the shadow mask, such that pixels are formed in the appropriate locations. When it is desirable to increase the substrate size, it is increasingly difficult to manipulate the shadow mask as part of the alignment process to form appropriately positioned pixels. A further disadvantage of the shadow mask method is that the mask holes can become plugged with time. Plugged holes on the mask lead to the undesirable result of non-functioning pixels on the EL display.

Donor materials have been known for many years for the purpose of laser thermal dye transfer of images as taught in US-A-4,772,582 and references therein. The process uses donor sheets to transfer different colors using a laser beam to heat up and thermally transfer dyes from the donor to the receiver. This method is used for high quality images but does not teach the transfer of EL materials.

A method for patterning high resolution organic EL displays has been disclosed in US-A-5,851,709 by Grande and others. This method is comprised of the following sequences of steps: 1) providing a substrate having opposing first and second surfaces; 2) forming a light-transmissive, heat-insulating layer over the first surface of the substrate; 3) forming a light-absorbing layer over the heat-insulating layer; 4) providing the substrate with an array of openings extending from the second surface to the heat-insulating layer; 5) providing a transferable, color-forming, organic donor layer formed on the light-absorbing layer; 6) precision aligning the donor substrate with the display substrate in an oriented relationship between the openings in the substrate and the corresponding color pixels on the device; and 7) employing a source of radiation for producing sufficient heat at the light-absorbing layer over the openings to cause the transfer of the organic layer on the donor substrate to the display substrate. A problem with the Grande and others approach is that patterning of an array of openings on the donor substrate is required. This creates many of the same problems as the shadow mask method, including the requirement for precision mechanical alignment between the donor substrate and the display substrate. A further problem is that the donor pattern is fixed and cannot be changed readily.

Littman and Tang (US-A-5,688,551) teach the patternwise transfer of organic EL material from an unpatterned donor sheet to an EL substrate. A series of patents by Wolk and others (US-A-6,114,088; US-A-6,140,009; US-A-6,214,520; and US-A-6,221,553) teach a method that can transfer the luminescent layer of an EL device from a donor element to a substrate by heating selected portions of the donor with a laser beam. These patents teach that contact or near contact are preferable for this transfer. Contact between the donor element and the substrate has problems such as sticking of the donor elements and substrates, and transfer of unwanted impurities or particles from the donor to the receiver.

It is therefore an object of the present invention to improve color and/or uniformity in the manufacture of OLED devices by laser thermal transfer.

This object is achieved by a method for depositing onto a substrate an organic emitter layer in the process of making an OLED device, comprising the steps of:
a) providing a donor element coated with the organic emitter layer having an organic emitter having a desired emission spectrum and which when subject to heat transfers to the substrate;
b) positioning the coated side of the donor element in a material transferring relationship at a predetermined distance relative to the substrate to deposit the emitter layer in an environment of reduced pressure, the predetermined distance being selected so that the spectrum of light emitted from the OLED device will be in the desired emission spectrum; and
c) heating the donor element to cause the transferable layer to transfer to form the emitter layer on the organic light-emitting device.

An advantage of the present invention is that it eliminates the problems caused by contact between the donor element and substrate. The present invention forms an organic emitter layer, prepared by a laser thermal transfer process that provides emissions that more closely model vacuum deposited organic emitter layers. A further advantage of this method is that the uniformity of the organic emitter layers is improved. It has been found that OLED devices made in accordance with the present invention have improved electroluminescent intensity and are more stable.
FIG. 1 shows one embodiment of the structure of a donor element prepared in accordance with this invention;
FIG. 2a shows a cross-sectional representation of the transfer of organic material from donor to substrate across a minimum gap by treatment with light;
FIG. 2b shows a cross-sectional representation of the transfer of organic material from donor to substrate across a larger gap by treatment with light;
FIG. 3 shows a cross-sectional representation of an OLED device prepared in accordance with this invention; and
FIG. 4 is a block diagram showing the overall steps involved in depositing an organic emitter layer onto a substrate.

Since device feature dimensions such as layer thicknesses are frequently in sub-micrometer ranges, the drawings are scaled for ease of visualization rather than dimensional accuracy.

The term "display" or "display panel" is employed to designate a screen capable of electronically displaying video images or text. The term "pixel" is employed in its art recognized usage to designate an area of a display panel that can be stimulated to emit light independently of other areas. The term "OLED device" is used in its art recognized meaning of a display device comprising organic light-emitting diodes as pixels. A color OLED device emits light of at least one color. The term "multicolor" is employed to describe a display panel that is capable of emitting light of a different hue in different areas. In particular, it is employed to describe a display panel that is capable of displaying images of different colors. These areas are not necessarily contiguous. The term "full color" is employed to describe multicolor display panels that are capable of emitting in the red, green, and blue regions of the visible spectrum and displaying images in any combination of hues. The red, green, and blue colors constitute the three primary colors from which all other colors can be generated by appropriately mixing these three primaries. The term "hue" refers to the intensity profile of light emission within the visible spectrum, with different hues exhibiting visually discernible differences in color. The pixel or subpixel is generally used to designate the smallest addressable unit in a display panel. For a monochrome display, there is no distinction between pixel or subpixel. The term "subpixel" is used in multicolor display panels and is employed to designate any portion of a pixel, which can be independently addressable to emit a specific color. For example, a blue subpixel is that portion of a pixel, which can be addressed to emit blue light. In a full-color display, a pixel generally comprises three primary-color subpixels, namely blue, green, and red. The term "pitch" is used to designate the distance separating two pixels or subpixels in a display panel. Thus, a subpixel pitch means the separation between two subpixels.

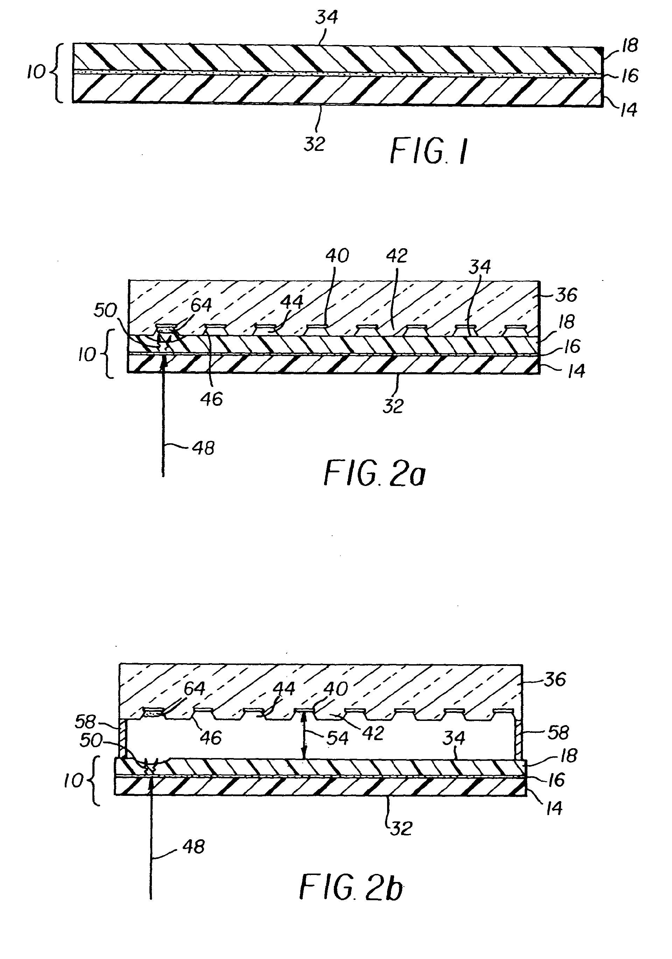

FIG. 1 shows in cross-sectional view one embodiment of the structure of a donor element 10 coated with an organic emitter layer 18. Donor element 10 includes at the minimum a flexible donor support element 14, which comprises the non-transfer surface 32 of donor element 10. Donor support element 14 can be made of any of several materials which meet at least the following requirements: The donor support element must be capable of maintaining the structural integrity during the light-to-heat-induced transfer step while pressurized on one side, and during any preheating steps contemplated to remove volatile constituents such as water vapor. Additionally, the donor support must be capable of receiving on one surface a relatively thin coating of organic donor material, and of retaining this coating without degradation during anticipated storage periods of the coated support. Support materials meeting these requirements include, for example, metal foils, certain plastic foils which exhibit a glass transition temperature value higher than a support temperature value anticipated to cause transfer of the transferable organic donor materials of the coating on the support, and fiber-reinforced plastic foils. While selection of suitable support materials can rely on known engineering approaches, it will be appreciated that certain aspects of a selected support material merit further consideration when configured as a donor support useful in the practice of the invention. For example, the support can require a multi-step cleaning and surface preparation process prior to precoating with transferable organic material. If the support material is a radiation-transmissive material, the incorporation into the support or onto a surface thereof, of a radiation-absorptive material can be advantageous to more effectively heat the donor support and to provide a correspondingly enhanced transfer of transferable organic donor material from the support to the substrate, when using a flash of radiation from a suitable flash lamp or laser light from a suitable laser.

Donor support element **14** is uniformly coated with radiation-absorbing layer **16** capable of absorbing radiation in a predetermined portion of the spectrum to produce heat. Radiation-absorbing material **16** can be a dye such as the dyes specified in US-A-5,578,416, a pigment such as carbon, or a metal such as nickel, chromium, titanium, and so forth.

Donor element **10** further includes organic emitter layer **18**. Organic emitter layer **18** is a transferable layer which, when subject to heat, can transfer to a substrate. Such heat can be applied directly or produced by light applied to radiation-absorbing material **16**. Donor support element **14** thus comprises non-transfer surface **32** and organic emitter layer **18** comprises coated side **34** of donor element **10**. Organic emitter layer **18** comprises one or more organic emitters, which are well known. As more fully described in US-A-4,769,292 and US-A-5,935,721, the organic emitter or light-emitting layer (LEL) of the organic EL element comprises a luminescent or fluorescent material where electroluminescence is produced as a result of electron-hole pair recombination in this region. The organic emitter can be comprised of a single material, but more commonly consists of a host material doped with a guest compound or compounds, also called dopants, where light emission comes primarily from the dopant and can be of any color. The host materials in the organic emitter can be an electron-transporting material, as defined below, a hole-transporting material, as defined below, or another material that supports electron-hole recombination. The dopant is usually chosen from highly fluorescent dyes, but phosphorescent compounds, for example, transition metal complexes as described in WO 98/55561, WO 00/18851, WO 00/57676, and WO 00/70655 are also useful. Dopants are typically coated as 0.01 to 10% by weight into the host material.

An important relationship for choosing a dye as a dopant is a comparison of the bandgap potential which is defined as the energy difference between the highest occupied molecular orbital and the lowest unoccupied molecular orbital of the molecule. For efficient energy transfer from the host to the dopant molecule, a necessary condition is that the band gap of the dopant is smaller than that of the host material.

Another important consideration for choosing an organic emitter is that the spectrum of light emitted from the resulting completed OLED device is in a desired emission spectrum, that is of an appropriate spectrum when energized in a completed device. For example, for a full-color OLED device, it is common to have one organic emitter with a desired emission spectrum in the green region of the visible spectrum, a second organic emitter with a desired emission spectrum in the blue region of the visible spectrum, and a third organic emitter with a desired emission spectrum in the red region of the visible spectrum.

Host and emitting molecules known to be of use include, but are not limited to, those disclosed in US-A-4,768,292; US-A-5,141,671; US-A-5,150,006; US-A-5,151,629; US-A-5,294,870; US-A-5,405,709; US-A-5,484,922; US-A-5,593,788; US-A-5,645,948; US-A-5,683,823; US-A-5,755,999; US-A-5,928,802; US-A-5,935,720; US-A-5,935,721; and US-A-6,020,078.

Metal complexes of 8-hydroxyquinoline and similar derivatives (Formula E) constitute one class of useful host compounds capable of supporting electroluminescence, and are particularly suitable for light emission of wavelengths longer than 500 nm, for example, green, yellow, orange, and red. 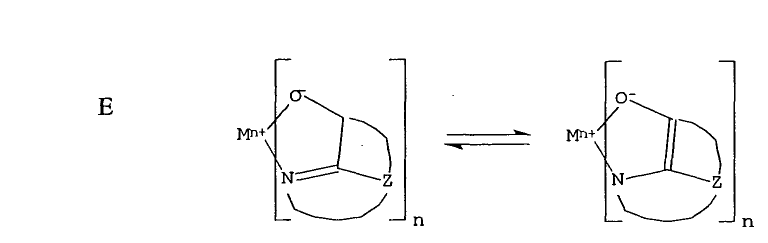 wherein:
M represents a metal;
n is an integer of from 1 to 3; and
Z independently in each occurrence represents the atoms completing a nucleus having at least two fused aromatic rings.

From the foregoing it is apparent that the metal can be monovalent, divalent, or trivalent metal. The metal can, for example, be an alkali metal, such as lithium, sodium, or potassium; an alkaline earth metal, such as magnesium or calcium; or an earth metal, such as boron or aluminum. Generally any monovalent, divalent, or trivalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is usually maintained at 18 or less.

Illustrative of useful chelated oxinoid compounds are the following:
CO-1: Aluminum trisoxine [alias, tris(8-quinolinolato)aluminum(III)]
CO-2: Magnesium bisoxine [alias, bis(8-quinolinolato)magnesium(II)]
CO-3: Bis[benzo{f}-8-quinolinolato]zinc (II)
CO-4: Bis(2-methyl-8-quinolinolato)aluminum(III)-µ-oxo-bis(2-methyl-8-quinolinolato) aluminum(III)
CO-5: Indium trisoxine [alias, tris(8-quinolinolato)indium]
CO-6: Aluminum tris(5-methyloxine) [alias, tris(5-methyl-8-quinolinolato) aluminum(III)]
CO-7: Lithium oxine [alias, (8-quinolinolato)lithium(I)].

Derivatives of 9,10-di-(2-naphthyl)anthracene (Formula F) constitute one class of useful hosts capable of supporting electroluminescence, and are particularly suitable for light emission of wavelengths longer than 400 nm, for example, blue, green, yellow, orange or red.

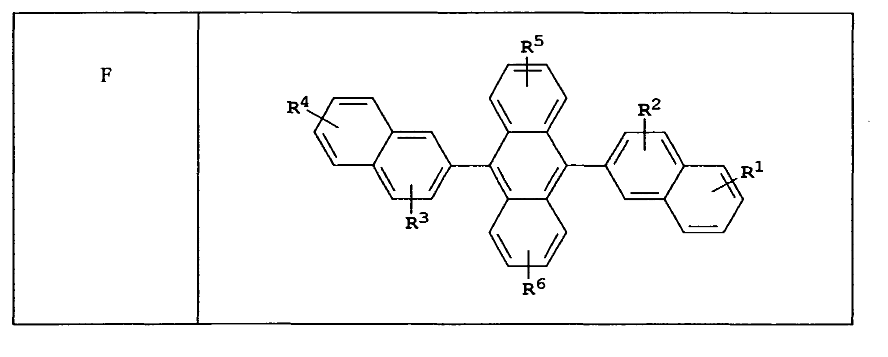

wherein R¹, R², R³, R⁴, R⁵, and R⁶ represent one or more substituents on each ring where each substituent is individually selected from the following groups:
Group 1: hydrogen, or alkyl of from 1 to 24 carbon atoms;
Group 2: aryl or substituted aryl of from 5 to 20 carbon atoms;
Group 3: carbon atoms from 4 to 24 necessary to complete a fused aromatic ring of anthracenyl; pyrenyl, or perylenyl;
Group 4: heteroaryl or substituted heteroaryl of from 5 to 24 carbon atoms as necessary to complete a fused heteroaromatic ring of furyl, thienyl, pyridyl, quinolinyl or other heterocyclic systems;
Group 5: alkoxylamino, alkylamino, or arylamino of from 1 to 24 carbon atoms; and
Group 6: fluorine, chlorine, bromine or cyano.

Benzazole derivatives (Formula G) constitute another class of useful hosts capable of supporting electroluminescence, and are particularly suitable for light emission of wavelengths longer than 400 nm, for example, blue, green, yellow, orange or red. 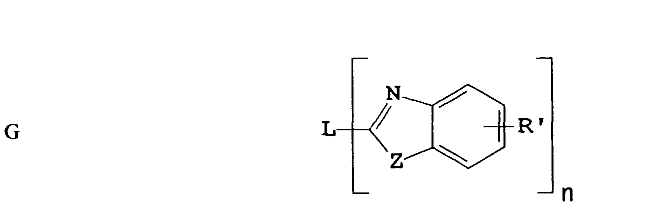 where:
n is an integer of 3 to 8;
Z is O, NR or S; and
R' is hydrogen; alkyl of from 1 to 24 carbon atoms, for example, propyl, t-butyl, heptyl, and the like; aryl or hetero-atom substituted aryl of from 5 to 20 carbon atoms for example phenyl and naphthyl, furyl, thienyl, pyridyl, quinolinyl and other heterocyclic systems; or halo such as chloro, fluoro; or atoms necessary to complete a fused aromatic ring;
L is a linkage unit consisting of alkyl, aryl, substituted alkyl, or substituted aryl, which conjugately or unconjugately connects the multiple benzazoles together.

An example of a useful benzazole is 2, 2', 2"-(1,3,5-phenylene)tris[1-phenyl-1H-benzimidazole].

Desirable fluorescent dopants include derivatives of anthracene, tetracene, xanthene, perylene, rubrene, coumarin, rhodamine, quinacridone, dicyanomethylenepyran compounds, thiopyran compounds, polymethine compounds, pyrilium and thiapyrilium compounds, and carbostyryl compounds. Illustrative examples of useful dopants include, but are not limited to, the following.

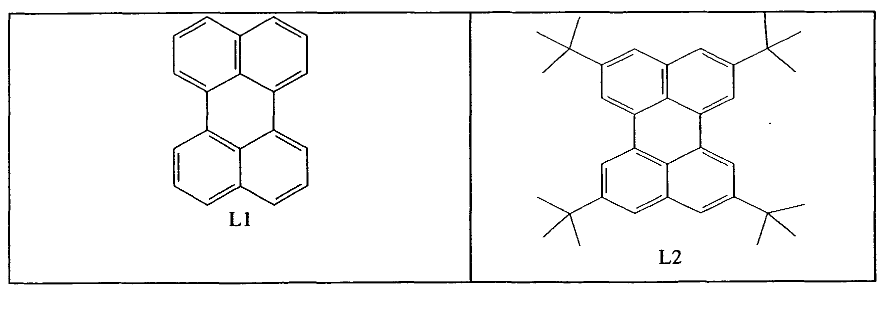

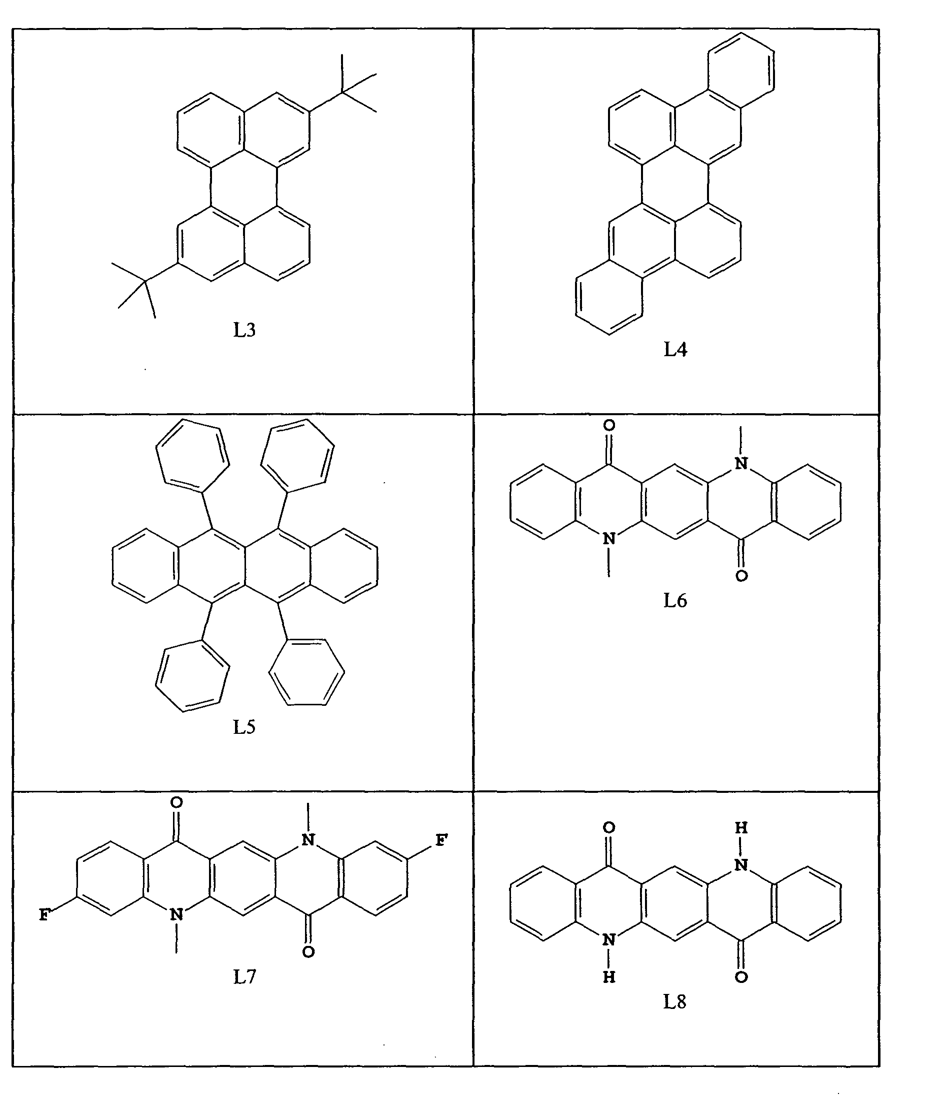

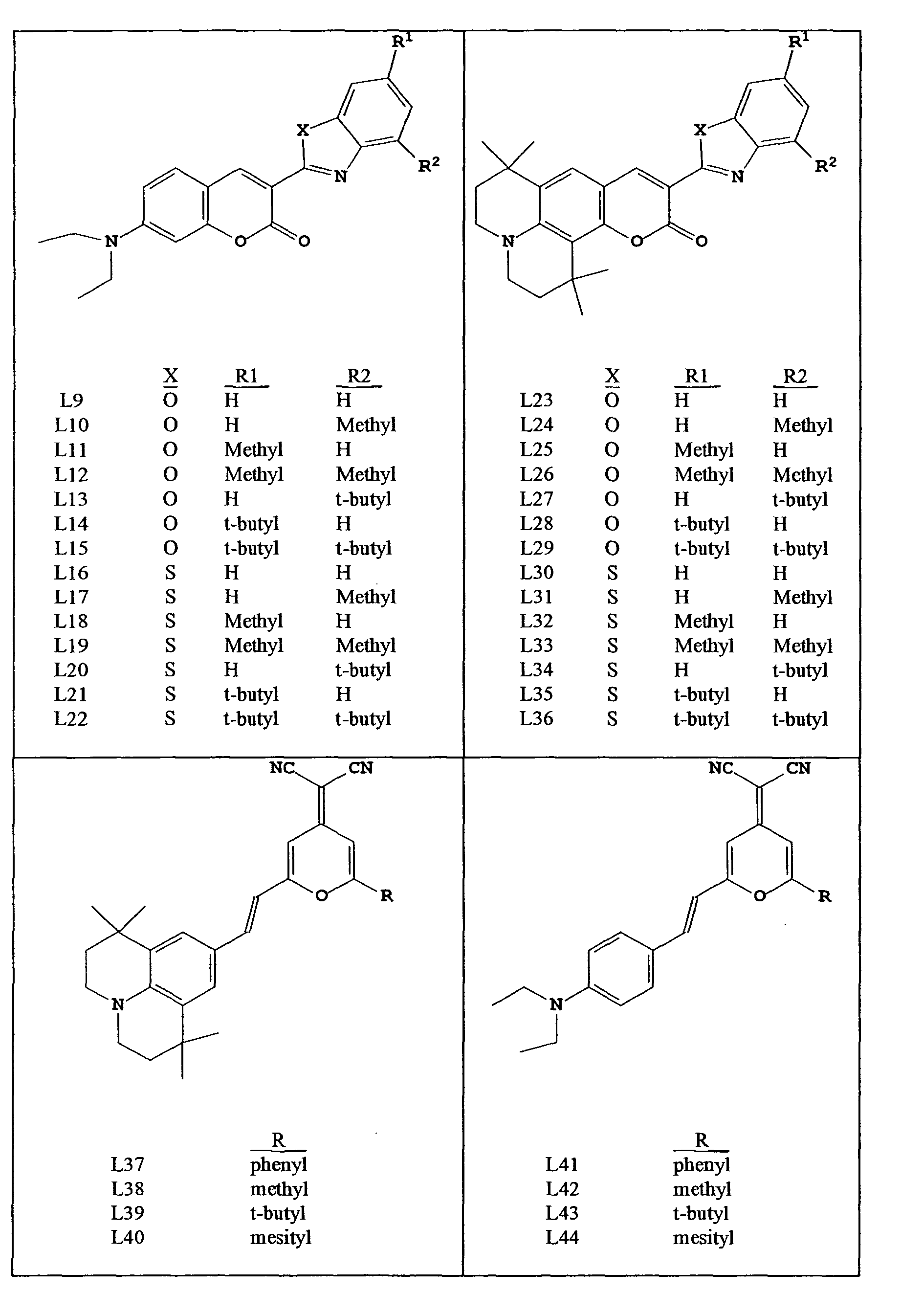

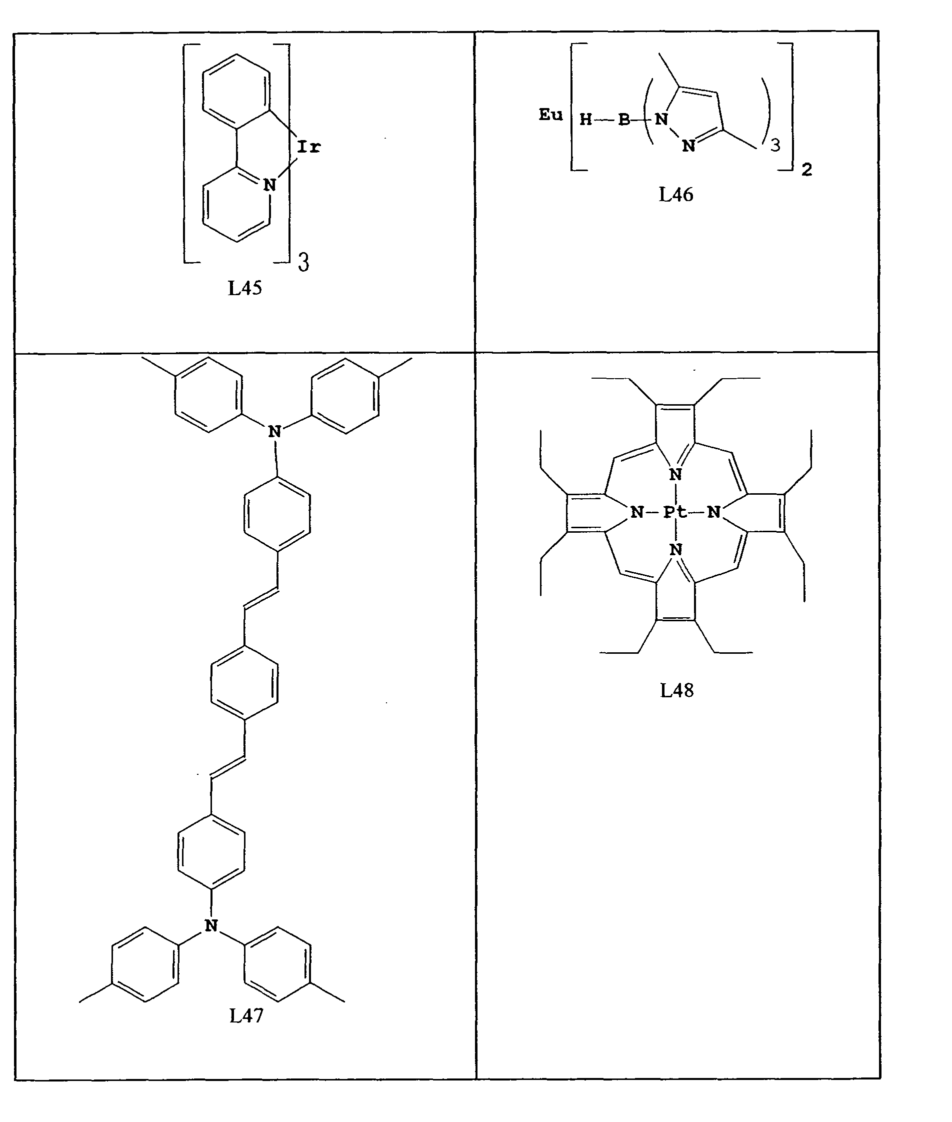

Other organic emissive materials can be polymeric substances, for example, polyphenylenevinylene derivatives, dialkoxy-polyphenylenevinylenes, poly-para-phenylene derivatives, and polyfluorene derivatives, as taught by Wolk and others in commonly assigned US-A-6,194,119 B 1 and references therein.

Donor element 10 can further include other layers, for example a hole-transporting material or an electron-transporting material as described below, which is not shown but can be a covering layer over organic emitter layer 18.

Hole-transporting materials are well known to include compounds such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine. Exemplary monomeric triarylamines are illustrated by Klupfel and others US-A-3,180,730. Other suitable triarylamines substituted with one or more vinyl radicals and/or comprising at least one active hydrogen containing group are disclosed by Brantley and others US-A-3,567,450 and US-A-3,658,520.

A more preferred class of aromatic tertiary amines are those which include at least two aromatic tertiary amine moieties as described in US-A-4,720,432 and US-A-5,061,569. Such compounds include those represented by structural Formula (A). 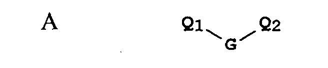 wherein:
Q₁ and Q₂ are independently selected aromatic tertiary amine moieties; and
G is a linking group such as an arylene, cycloalkylene, or alkylene group of a carbon to carbon bond.
In one embodiment, at least one of Q₁ or Q₂ contains a polycyclic fused ring structure, for example, a naphthalene. When G is an aryl group, it is conveniently a phenylene, biphenylene, or naphthalene moiety.

A useful class of triarylamines satisfying structural Formula (A) and containing two triarylamine moieties is represented by structural Formula (B) 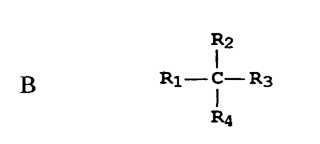 where:
R₁ and R₂ each independently represent a hydrogen atom, an aryl group, or an alkyl group or R₁ and R₂ together represent the atoms completing a cycloalkyl group; and
R₃ and R₄ each independently represent an aryl group, which is in turn substituted with a diaryl substituted amino group, as indicated by structural Formula (C) 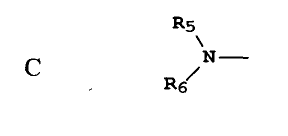
wherein R₅ and R₆ are independently selected aryl groups.
In one embodiment, at least one of R₅ or R₆ contains a polycyclic fused ring structure, for example, a naphthalene.

Another class of aromatic tertiary amines is the tetraaryldiamines. Desirable tetraaryldiamines include two diarylamino groups, such as indicated by Formula (C), linked through an arylene group. Useful tetraaryldiamines include those represented by Formula (D). 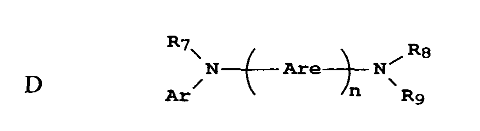 wherein:
each Are is an independently selected arylene group, such as a phenylene or anthracene moiety,
n is an integer of from 1 to 4, and
Ar, R₇, R₈, and R₉ are independently selected aryl groups.

In a typical embodiment, at least one of Ar, R₇, R₈, and R₉ is a polycyclic fused ring structure, for example, a naphthalene.

The various alkyl, alkylene, aryl, and arylene moieties of the foregoing structural Formulae (A), (B), (C), (D), can each in turn be substituted. Typical substituents include alkyl groups, alkoxy groups, aryl groups, aryloxy groups, and halogen such as fluoride, chloride, and bromide. The various alkyl and alkylene moieties typically contain from about 1 to 6 carbon atoms. The cycloalkyl moieties can contain from 3 to about 10 carbon atoms, but typically contain five, six, or seven ring carbon atoms-for example, cyclopentyl, cyclohexyl, and cycloheptyl ring structures. The aryl and arylene moieties are usually phenyl and phenylene moieties.

The hole-transporting layer can be formed of a single or a mixture of aromatic tertiary amine compounds. Specifically, one can employ a triarylamine, such as a triarylamine satisfying the Formula (B), in combination with a tetraaryldiamine, such as indicated by Formula (D). When a triarylamine is employed in combination with a tetraaryldiamine, the latter is positioned as a layer interposed between the triarylamine and the electron injecting and transporting layer. Illustrative of useful aromatic tertiary amines is the following:
1,1-Bis(4-di-***p***-tolylaminophenyl)cyclohexane
1,1-Bis(4-di-***p***-tolylaminophenyl)-4-phenylcyclohexane
4,4'-Bis(diphenylamino)quadriphenyl
Bis(4-dimethylamino-2-methylphenyl)-phenylmethane
N,N,N-Tri(***p***-tolyl)amine
4-(di-p-tolylamino)-4'-[4(di-***p***-tolylamino)-styryl]stilbene
N,N,N',N'-Tetra-***p***-tolyl-4-4'-diaminobiphenyl
N,N,N',N'-Tetraphenyl-4,4'-diaminobiphenyl
N-Phenylcarbazole
Poly(N-vinylcarbazole)
N,N'-di-1-naphthalenyl-N,N'-diphenyl-4,4'-diaminobiphenyl
4,4'-Bis[N-(1-naphthyl)-N-phenylamino]biphenyl
4,4"-Bis[N-(1-naphthyl)-N-phenylamino]p-terphenyl
4,4'-Bis[N-(2-naphthyl)-N-phenylamino]biphenyl
4,4'-Bis[N-(3-acenaphthenyl)-N-phenylamino]biphenyl
1,5-Bis[N-(1-naphthyl)-N-phenylamino]naphthalene
4,4'-Bis[N-(9-anthryl)-N-phenylamino]biphenyl
4,4"-Bis[N-(1-anthryl)-N-phenylamino]-***p***-terphenyl
4,4'-Bis[N-(2-phenanthryl)-N-phenylamino]biphenyl
4,4'-Bis[N-(8-fluoranthenyl)-N-phenylamino]biphenyl
4,4'-Bis[N-(2-pyrenyl)-N-phenylamino]biphenyl
4,4'-Bis[N-(2-naphthacenyl)-N-phenylamino]biphenyl
4,4'-Bis[N-(2-perylenyl)-N-phenylamino]biphenyl
4,4'-Bis[N-(1-coronenyl)-N-phenylamino]biphenyl
2,6-Bis(di-***p***-tolylamino)naphthalene
2,6-Bis[di-( 1-naphthyl)amino]naphthalene
2,6-Bis[N-(1-naphthyl)-N-(2-naphthyl)amino]naphthalene
N,N,N',N'-Tetra(2-naphthyl)-4,4"-diamino-***p***-terphenyl
4,4'-Bis {N-phenyl-N-[4-(1-naphthyl)-phenyl]amino}biphenyl
4,4'-Bis[N-phenyl-N-(2-pyrenyl)amino]biphenyl
2,6-Bis[N,N-di(2-naphthyl)amine]fluorene
1,5-Bis[N-(1-naphthyl)-N-phenylamino]naphthalene.

Another class of useful hole-transporting materials includes polycyclic aromatic compounds as described in EP 1 009 041. Tertiary aromatic amines with more than two amine groups can be used including oligomeric materials. In addition, polymeric hole-transporting materials can be used such as poly(N-vinylcarbazole) (PVK), polythiophenes, polypyrrole, polyaniline, and copolymers such as poly(3,4-ethylenedioxythiophene)/poly(4-styrenesulfonate) also called PEDOT/PSS.

FIG. 2a shows a cross-sectional representation of a method for depositing an organic emitter layer 18 from donor element 10 onto portions of substrate **36** across a minimum gap by treatment with light in the process of making an OLED device. Substrate **36** can be an organic solid, an inorganic solid, or a combination of organic and inorganic solids that provides a surface for receiving the emissive material from a donor. Substrate **36** can be rigid or flexible and can be processed as separate individual pieces, such as sheets or wafers, or as a continuous roll. Typical substrate materials include glass, plastic, metal, ceramic, semiconductor, metal oxide, semiconductor oxide, semiconductor nitride, or combinations thereof. Substrate **36** can be a homogeneous mixture of materials, a composite of materials, or multiple layers of materials. Substrate **36** can be an OLED substrate, that is a substrate commonly used for preparing OLED devices, for example, active-matrix low-temperature polysilicon TFT substrate. The substrate **36** can either be light-transmissive or opaque, depending on the intended direction of light emission. The light-transmissive property is desirable for viewing the EL emission through the substrate. Transparent glass or plastic is commonly employed in such cases. For applications where the EL emission is viewed through the top electrode, the transmissive characteristic of the bottom support is immaterial, and therefore can be light-transmissive, light-absorbing or light reflective. Substrates for use in this case include, but are not limited to, glass, plastic, semiconductor materials, ceramics, and circuit board materials, or any others commonly used in the formation of OLED devices, which can be either passive-matrix devices or active-matrix devices. Substrate **36** can be coated with other layers prior to this step.

Coated side **34** of donor element **10** has been positioned in a material transferring relationship relative to substrate **36**. By material transferring relationship, we mean that donor element **10** and substrate **36** are positioned in a way to facilitate the transfer of organic emitter from organic emitter layer **18** to substrate **36**. Coated side **34** of donor element **10** is positioned at a predetermined distance **44** relative to the top of an anode, or the top of a top layer coated over an anode, on thin-film transistor **40**. Predetermined distance can be provided in a number of ways. In FIG. 2a, predetermined distance **44** is provided by the structure of substrate **36**. The predetermined distance can also be provided by the structure of donor element **10**, for example, by the addition of spacer beads to the surface of donor element **10**, as described by Boroson and others in commonly assigned US-A-5,714,301.

Donor element **10** has been prepared with radiation-absorbing layer **16** and predetermined distance **44** is maintained by the structure of thin-film transistors **40** and intervening raised surface portions **42**. It is understood that in other embodiments, predetermined distance **44** can be maintained in other ways, for example, by the use of spacer elements on coated side **34** of donor element **10**, as taught in commonly assigned U.S. Patent Application Serial No. 10/060,837 filed January 30, 2002 by Mitchell S. Burberry and others, entitled "Using Spacer Elements to Make Electroluminescent Display Devices", the disclosure of which is incorporated herein by reference. The gap of a predetermined distance is maintained in an environment of reduced pressure wherein the mean free path is larger than the predetermined distance. This means that material crossing the gap will have a low probability of colliding with any residual gases. In general, this means a pressure of **1** Torr or less. A pattern of laser light **48** illuminates non-transfer surface **32** of donor element **10**. A large portion of the laser light **48** impinging on radiation-absorbing layer **16** of donor element **10** will be converted to heat **50**, but this will only happen at selectively irradiated portions of donor element **10**. This heats organic emitter layer **18** of donor element **10** in the immediate vicinity of laser light **48**. Some or all of the heated portion of organic emitter layer **18** transfers by vaporization transport to form organic emitter layer **64** onto receiving surface **46** of organic light-emitting device substrate **36** in a patterned transfer. Vaporization transport is defined as the process whereby material is transported across a gap whether it is as individual molecules or small clusters of molecules. This can include processes such as sublimation, vaporization, and ablation. Organic emitter layer **18** is drawn for clarity as a single layer, but it will be understood that it can represent a multilayer coating as described herein.

FIG. 2b shows a cross-sectional representation of a method for depositing an organic emitter layer **18** from donor element **10** onto portions of substrate **36** across a larger gap by treatment with light in the process of making an OLED device. In this embodiment, predetermined distance **54** is maintained by spacer elements **58** and by predetermined distance **44** from the structure of thin-film transistors **40**. The gap is maintained in an environment of reduced pressure wherein the mean free path is larger than the predetermined distance. This means that material crossing the gap will have a low probability of colliding with any residual gases. In general, this means a pressure of 1 Torr or less. A pattern of laser light **48** illuminates non-transfer surface **32**. Heat **50** is produced when laser light **48** strikes radiation-absorbing layer **16**. This heats organic emitter layer **18** in the immediate vicinity of laser light **48**. Some or all of the heated portion of organic emitter layer **18** transfers by vaporization transport to form organic emitter layer **64** on receiving surface **46** of substrate **36** in a patterned transfer. Organic emitter layer **18** is drawn for clarity as a single layer, but it will be understood that it can represent a multilayer coating as described herein.

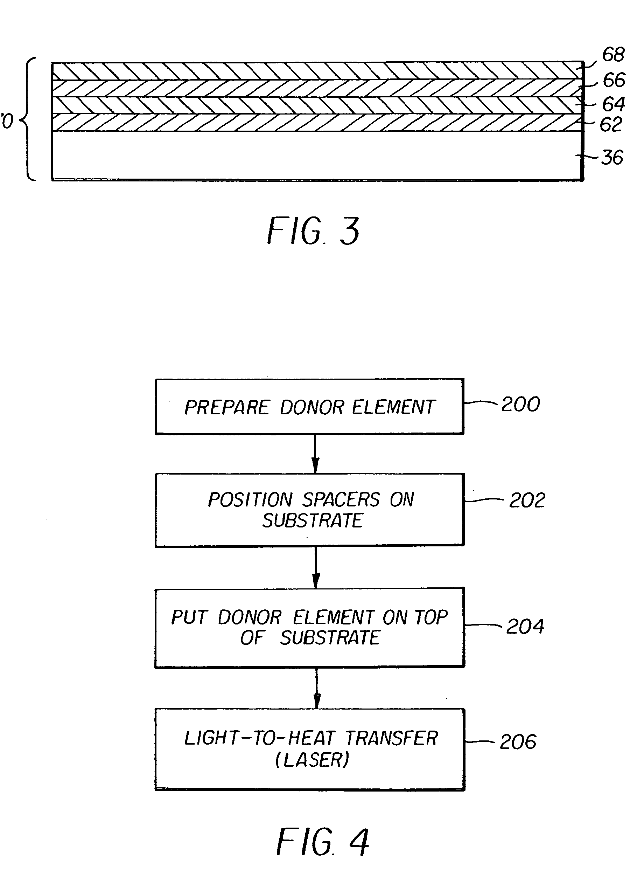

FIG. 3 shows an OLED device prepared in accordance with the method of this invention. OLED device **70** includes anode **62** and cathode **68**. OLED device **70** also includes organic emitter layer **64** and electron-transporting layer **66**. Electron-transporting layer **66** is disposed between cathode **68** and organic emitter layer **64**.

The conductive anode layer is commonly formed over the substrate and, when EL emission is viewed through the anode, should be transparent or substantially transparent to the emission of interest. Common transparent anode materials used in this invention are indium-tin oxide (ITO), indium-zinc oxide (IZO), and tin oxide, but other metal oxides can work including, but not limited to, aluminum- or indium-doped zinc oxide, magnesium-indium oxide, and nickel-tungsten oxide. In addition to these oxides, metal nitrides, such as gallium nitride, and metal selenides, such as zinc selenide, and metal sulfides, such as zinc sulfide, can be used as an anode material. For applications where EL emission is viewed through the top electrode, the transmissive characteristics of the anode material are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials can be deposited by any suitable means such as evaporation, sputtering, chemical vapor deposition, or electrochemical means. Anode materials can be patterned using well known photolithographic processes. Optionally, anodes can be polished prior to application of other layers to reduce surface roughness so as to minimize shorts or enhance reflectivity.

When light emission is through the anode, the cathode material can be comprised of nearly any conductive material. Desirable materials have good film-forming properties to ensure good contact with the underlying organic layer, promote electron injection at low voltage, and have good stability. Useful cathode materials often contain a low work function metal (< 4.0 eV) or metal alloy. One preferred cathode material is comprised of a Mg:Ag alloy wherein the percentage of silver is in the range of 1 to 20%, as described in US-A-4,885,221. Another suitable class of cathode materials includes bilayers comprised of a thin layer of a low work function metal or metal salt capped with a thicker layer of conductive metal. One such cathode is comprised of a thin layer of LiF followed by a thicker layer of A1 as described in US-A-5,677,572. Other useful cathode materials include, but are not limited to, those disclosed in US-A-5,059,861; US-A-5,059,862; and US-A-6,140,763.

When light emission is viewed through the cathode, the cathode must be transparent or nearly transparent. For such applications, metals must be thin or one must use transparent conductive oxides, or a combination of these materials. Optically transparent cathodes have been described in more detail in US-A-4,885,211 and US-A-5,247,190; JP 3,234,963; US-A-5,703,436; US-A-5,608,287; US-A-5,837,391; US-A-5,677,572; US-A-5,776,622; US-A-5,776,623; US-A-5,714,838; US-A-5,969,474; US-A-5,739,545; US-A-5,981,306; US-A-6,137,223; US-A-6,140,763; US-A-6,172,459; EP 1 076 368; US-A-6,278,236 and US-A-6,284,393. Cathode materials can be deposited by evaporation, sputtering, or chemical vapor deposition. When needed, patterning can be achieved through many well known methods including, but not limited to, through-mask deposition, integral shadow masking as described in US-A-5,276,380 and EP 0 732 868, laser ablation, and selective chemical vapor deposition.

Preferred electron-transporting materials for use in electron-transporting layer **66** of this invention are metal chelated oxinoid compounds, including chelates of oxine itself (also commonly referred to as 8-quinolinol or 8-hydroxyquinoline). Such compounds help to inject and transport electrons and exhibit both high levels of performance and are readily fabricated in the form of thin films. Exemplary of contemplated oxinoid compounds are those satisfying structural Formula (E), previously described.

Other electron-transporting materials include various butadiene derivatives as disclosed in US-A-4,356,429 and various heterocyclic optical brighteners as described in US-A-4,539,507. Benzazoles satisfying structural Formula (G) are also useful electron transporting materials. Triazines are also known to be useful as electron transporting materials.

Other electron-transport materials can be polymeric substances, for example, polyphenylenevinylene derivatives, poly-para-phenylene derivatives, polyfluorene derivatives, polythiophenes, polyacetylenes, and other conductive polymeric organic materials such as those listed in commonly assigned US-A-6,221,553 B1 and references therein.

In some instances, a single layer can serve the function of supporting both light emission and electron transportation, and will therefore include emissive material and electron transport material.

Turning now to FIG. 4, there is shown a block diagram showing the overall steps in a method for depositing an organic emitter layer onto a substrate in the process of making an OLED device in accordance with this invention. First, a donor element **10** is prepared (Step **200**). A spacer element or elements **58** is/are placed on substrate **36** (Step **202**). Donor element **10** is then placed on top of spacer elements **58** (Step **204**). Laser light **48** is then used to effect light-to-heat-induced transfer of organic emitter layer **18** from donor element **10** to substrate **36** (Step **206**). This process is explained in greater detail in the Examples that follow.

The invention and its advantages can be better appreciated by the following comparative Examples.

### Donor Element Example 1 (Blue donor element)

A donor element satisfying the requirements of the invention was constructed in the following manner:
1. An absorption layer of 30 nm of chromium was vacuum deposited onto a 75 micron polysulfone (UDEL) donor substrate.
2. A layer of 20 nm of 2-tert-butyl-9,10-bis(2-naphthyl)anthracene (TBADN) with 1.25% tetra-tert-butyl-perylene (TBP) was vacuum deposited onto the chromium layer from two separate evaporative boats.

### Donor Element Example 2 (Red donor element)

A donor element satisfying the requirements of the invention was constructed in the manner described for donor element Example 1, except step 2 was as follows:
2. A layer of 20 nm, total coverage, of 49% TBADN, 49% tris(8-hydroxyquinoline)aluminum (ALQ), and 2% 4-(dicyanomethylene)-2-t-butyl-6-(1,1,7,7-tetramethyljulolidyl-9-enyl)-4H-pyran (DCJTB) was vacuum deposited onto the chromium layer from three separate evaporation boats.

### Donor Element Example 3 (Green donor element)

A donor element satisfying the requirements of the invention was constructed in the manner described for donor element Example 1, except step 2 was as follows:
2. A layer of 20 nm of TBADN with 2% Green Dopant I was vacuum deposited onto the chromium layer from two separate evaporative boats. Green Dopant I:

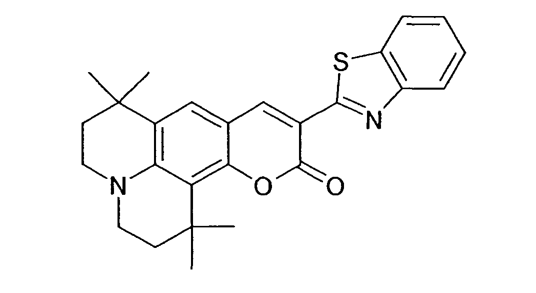

### OLED Device Example 1

A comparative OLED device was constructed in the following manner:
1. Onto a clean glass OLED substrate, a layer of 40 to 80 nm indium-tin oxide transparent electrode was vacuum deposited.
2. The resulting surface was treated with a plasma oxygen etch, followed by plasma deposition of ∼0.1 nm of CFₓ.
3. A 170 nm hole-transport layer of NPB was vacuum deposited onto the surface.
4. The donor element prepared in donor element Example 1 was placed on top of the NPB layer and held in proximal contact using vacuum (1 x 10⁻³ Torr) with the aid of a cover glass. In regions of the OLED substrate in which emission is desired, transfer of the emissive material from the donor element was effected by irradiation through the polysulfone substrate with an infrared laser beam of 6W power. The beam size was approximately 14 microns by 5 mm to the 1/e² intensity point. The beam was scanned in a direction perpendicular to the long dimension of the beam at 0.144 m/s. Successive swaths were exposed by translating the width of the beam in a direction perpendicular to the scan direction between scans.
5. An electron-transport layer 35 nm of tris(8-hydroxyquinoline)aluminum (ALQ) was vacuum deposited onto the emissive layer.
6. An electrode was formed over the electron-transport layer by codepositing 20 nm silver and 200 nm magnesium by vacuum deposition.
7. A cover plate of metal was sealed over the coated side of the glass to encapsulate the deposited layers.

### OLED Device Example 2

An OLED device satisfying the requirements of this invention was constructed in the manner described for OLED device Example 1 except the donor element used in step 4 was separated from the NPB layer by 10 micron shim stock having 2mm x 2mm openings to allow transfer in the electrode area.

### OLED Device Examples 3-5

An OLED device satisfying the requirements of this invention was constructed in the manner described for OLED device Example 2 except the shim stock used had thickness of 25 microns, 68 microns, and 125 microns, respectively.

### OLED Device Example 6

An evaporative comparative OLED device was constructed in the following manner:
1. Onto a clean flat glass OLED substrate, a layer of 40 to 80 nm indium-tin oxide transparent electrode was vacuum deposited.
2. The resulting surface was treated with a plasma oxygen etch, followed by plasma deposition of ∼0.1 nm of CFₓ.
3. A 140 nm hole-transport layer of NPB was vacuum deposited onto the surface.
4. A layer of 20 nm of TBADN with 1.25% TBP was vacuum deposited onto the NPB layer from two separate evaporative boats.
5. An electron-transport layer 35 nm of tris(8-hydroxyquinoline)aluminum (ALQ) was vacuum deposited onto the emissive layer.
6. An electrode was formed over the electron-transport layer by codepositing 20 nm silver and 200 nm magnesium by vacuum deposition.
7. A cover plate of metal was sealed over the coated side of the glass to encapsulate the deposited layers.

### OLED Device Example 7

An evaporative comparative OLED device was constructed in the manner described for OLED device Example 6 except the substrate used in step 1 was an OLED substrate having 1 micron photoresist wells in the electrode area.

Device testing consisted of putting a constant current of 20 mA through the constructed OLED devices with a programmable current source. The light output was monitored with a Photo Research PR650 spectrophotometer. Initial radiance and CIE color coordinates x and y were recorded. Device testing also consisted of putting a constant current through the constructed OLED devices and recording micrograph of electroluminescence obtained to determine transfer uniformity. Devices transferred with zero gap exhibited non-uniformities consisting of interference-like fringes in the luminescence pattern. These patterns were judged to be strong, medium, or none. The results are shown in Table 1.

**Table 1**

| Example # | Example Type | Gap | CIE X | CIE Y | Fringing artifact |
|---|---|---|---|---|---|
| 1 | Comparative | 0 | 0.184 | 0.274 | S |
| 2 | Invention | 10 | 0.175 | 0.264 | N |
| 3 | Invention | 25 | 0.174 | 0.260 | N |
| 4 | Invention | 68 | 0.171 | 0.248 | N |
| 5 | Invention | 125 | 0.168 | 0.243 | N |
| 6 | Evaporative comparative | ― | 0.160 | 0.251 | N |
| 7 | Evaporative comparative | ― | 0.145 | 0.202 | N |
| * S = Strong fringing pattern, M = medium fringing, N = no fringing | | | | | |

### OLED Device Example 8

A comparative OLED device was constructed in the manner described for OLED device Example 1 except the donor element prepared in donor element Example 2 was used in step 4.

### OLED Device Example 9

An OLED device satisfying the requirements of this invention was constructed in the manner described for OLED device Example 8 except the donor element used in step 4 was separated from the NPB layer by 10 micron shim stock having 2mm x 2mm openings to allow transfer in the electrode area.

### OLED Device Examples 10-12

An OLED device satisfying the requirements of this invention was constructed in the manner described for OLED device Example 9 except the shim stock used had thickness of 25 microns, 68 microns, and 125 microns, respectively.

Device testing consisted of putting a constant current through the constructed OLED devices and recording micrograph of electroluminescence obtained to determine transfer uniformity. Devices transferred with zero gap exhibited non-uniformities consisting of interference-like fringes in the luminescence pattern. These patterns were judged to be strong, medium, or none. The results are shown in Table 2.

**Table 2**

| Example # | Example Type | Gap | Fringing artifact* |
|---|---|---|---|
| 8 | Comparative | 0 | S |
| 9 | Invention | 10 | S |
| 10 | Invention | 25 | N |
| 11 | Invention | 68 | N |
| 12 | Invention | 125 | N |

| | | | |
|---|---|---|---|
| * S = Strong fringing pattern, M = medium fringing, N = no fringing | | | |

### OLED Device Example 13

A comparative OLED device was constructed in the manner described for OLED device Example 1 except the donor element prepared in donor element Example 3 was used in step 4.

### OLED Device Example 14

An OLED device satisfying the requirements of this invention was constructed in the manner described for OLED device Example 13 except the donor element used in step 4 was separated from the NPB layer by 10 micron shim stock having 2mm x 2mm openings to allow transfer in the electrode area.

### OLED Device Examples 15-17

An OLED device satisfying the requirements of this invention was constructed in the manner described for OLED device Example 14 except the shim stock used had thickness of 25 microns, 68 microns, and 125 microns, respectively.

Device testing consisted of putting a constant current through the constructed OLED devices and recording micrograph of electroluminescence obtained to determine transfer uniformity. Devices transferred with zero gap exhibited non-uniformities consisting of interference-like fringes in the luminescence pattern. These patterns were judged to be strong, medium, or none. The results are shown in Table 3.

**Table 3**

| Example # | Example Type | Gap | Fringing artifact* |
|---|---|---|---|
| 13 | Comparative | 0 | S |
| 14 | Invention | 10 | S |
| 15 | Invention | 25 | M |
| 16 | Invention | 68 | N |
| 17 | Invention | 125 | N |

| | | | |
|---|---|---|---|
| * S = Strong fringing pattern, M = medium fringing, N = no fringing | | | |

### Results

For blue, color improves as both x and y decrease. The data in Table 1 show that blue color did improve as the gap increased. This suggests that selecting a predetermined distance of 4 micrometers or greater can lead to an improvement in emission spectrum. The predetermined distance can be selected so that the spectrum of light emitted from the OLED device will be in the desired emission wavelength. Red and green cells did not change color appreciably with increasing gap.

Blue, red, and green devices transferred with zero gap exhibited interference-like fringes in the electroluminescence pattern. These appear to correspond to the topographical contours reflecting tiny space variations between the donor and the receiver induced by irregularities. Larger gaps showed successively less susceptibility to fringing. Gaps greater than 10 microns exhibited little or no fringing patterns. This suggests that a selecting a predetermined distance of 25 micrometers or greater can lead to an improvement in uniformity. An upper limit in predetermined distance is created by dispersion of organic emitter layer 64 to locations on substrate 36 other than the desired location. Such upper limit is on the order of 75 micrometers.

The present invention speculates that increasing gap increases the uniformity of transfer by averaging the spatial distribution and arrival times of transferred material form different locations on the donor. The laser transfer process is complex and can effect the emissive layer of different materials in various ways. Blue emissive cells, for example, are more susceptible to unwanted green emission because energy transfer to A1Q₃ states is exothermic. The uniformity and morphological changes with increasing gap can effect the distribution of recombination centers, reducing the unwanted green. Red cells are less susceptible to unwanted green emission because the energy levels of red dopants are lower than the green states of Alq₃. In green cells emission from the Alq₃ is practically indistinguishable from the green emission layer. In all cells, red, green and blue, increasing gap produced more uniform emission as observed in the redetection of fringe-like artifacts in the electroluminescence.

Other features of the invention are included below.

The method wherein the organic emitter has a desired emission spectrum in the blue region of the visible spectrum.

The method wherein the organic emitter has a desired emission spectrum in the green region of the visible spectrum.

The method wherein the organic emitter has a desired emission spectrum in the red region of the visible spectrum.

The method wherein the predetermined distance is provided by the structure of the donor element.

The method wherein the predetermined distance is provided by the structure of the substrate.

The method wherein the predetermined distance is provided by spacer elements.

The method wherein the organic emitter has a desired emission spectrum in the green region of the visible spectrum.

The method wherein the organic emitter has a desired emission spectrum in the red region of the visible spectrum.

The method wherein the predetermined distance is provided by the structure of the donor element.

The method wherein the predetermined distance is provided by the structure of the substrate.

## Claims

1. A method for depositing onto a substrate an organic emitter layer in the process of making an OLED device, comprising the steps of:
a) providing a donor element coated with the organic emitter layer having an organic emitter having a desired emission spectrum and which when subject to heat transfers to the substrate;
b) positioning the coated side of the donor element in a material transferring relationship at a predetermined distance relative to the substrate to deposit the emitter layer in an environment of reduced pressure, the predetermined distance being selected so that the spectrum of light emitted from the OLED device will be in the desired emission spectrum; and
c) heating the donor element to cause the transferable layer to transfer to form the emitter layer on the organic light-emitting device.

2. The method of claim 1 wherein the predetermined distance is at least 4 micrometers and less than 75 micrometers.

3. The method of claim 2 wherein the predetermined distance is at least 25 micrometers.

4. The method of claim 1 wherein the organic emitter layer comprises a dopant and a host material.

5. In a method of making an OLED device including an anode and a cathode and an organic emitter layer and an electron-transporting layer disposed between the cathode and the organic emitter layer, the improvement of forming the emitter layer, comprising the steps of:
a) providing a donor element coated with the organic emitter layer including an organic emitter having a desired emission spectrum and which when subject to heat transfers onto a surface of the OLED device;
b) positioning the coated side of the donor element in a material transferring relationship at a predetermined distance relative to the top of the anode or to the top of the top layer coated over the anode in an environment of reduced pressure, the predetermined distance being selected so that the spectrum of light emitted from the completed OLED device is in the desired emission spectrum; and
c) illuminating the donor element with laser light to heat the donor element that causes the transferable layer to transfer to form the emitter layer onto the organic light-emitting device.

6. The method of claim 5 wherein the predetermined distance is at least 4 micrometers and less than 75 micrometers.

7. The method of claim 6 wherein the predetermined distance is at least 25 micrometers.

8. The method of claim 5 wherein the organic emitter layer comprises a dopant and a host material.

9. The method of claim 5 wherein the organic emitter has a desired emission spectrum in the blue region of the visible spectrum.

10. The method of claim 5 wherein the predetermined distance is provided by spacer elements.
